# EUROPEAN PATENT SPECIFICATION

(11) **EP 3 509 104 B1**
(45) Date of publication and mention of the grant of the patent: **23.02.2022**
(21) Application number: 17837322.1
(22) Date of filing: 07.08.2017
(51) Int. Cl.: H01L 27/142, G21H 1/06, H01L 31/115, H02J 7/00

(54) **BETAVOLTAIC BATTERY**
BETAVOLTAIKBATTERIE
BATTERIE BÊTAVOLTAÏQUE

(30) Priority: 04.08.2016 RU 2016132280
(43) Date of publication of application: 10.07.2019
(73) Proprietor: Federal State Unitary Enterprise "Mining and Chemical Combine" (FSUE "MCC"), Zheleznogorsk, Krasnoyarsky Region 662972 (RU)
(72) Inventor: GAVRILOV, Petr Mikhailovich, Krasnoyarsky krai Zheleznogorsk 662971 (RU); MERKULOV, Igor Alexandrovich, Krasnoyarsky krai Zheleznogorsk 662971 (RU); DRUZ, Dmitry Vitalyevich, Krasnoyarsky krai Zheleznogorsk 662978 (RU); TIKHOMIROV, Denis Valeryevich, Krasnoyarsky krai Zheleznogorsk 662980 (RU); BARAKOV, Boris Nikolayevich, Krasnoyarsky krai Zheleznogorsk 662971 (RU); KOZLOVSKY, Andrey Petrovich, Krasnoyarsky krai Zheleznogorsk 662971 (RU); PERETOKIN, Alexey Sergeyevich, Krasnoyarsky krai Zheleznogorsk 662970 (RU); ZHURAVLYOV, Konstantin Sergeyevich, Novosibirsk 630090 (RU); GILINSKY, Alexandr Mikhailovich, Novosibirsk 630090 (RU); ZELENKOV, Pavel Viktorovich, Krasnoyarsk 660069 (RU); LELEKOV, Alexandr Timofeyevich, Krasnoyarsk 660036 (RU); SIDOROV, Viktor Gennadyevich, Krasnoyarsk 660133 (RU); KOVALYOV, Igor Vladimirovich, Krasnoyarsk 660006 (RU); BOGDANOV, Sergey Viktorovich, Krasnoyarsk 660059 (RU)
(74) Representative: Friese Goeden Patentanwälte PartGmbB
(86) International application number: PCT/RU2017/000575
(87) International publication number: WO 2018/026314

(56) References cited:
- WO-A2-2007/082168
- RU-U1- 124 856
- US-A1- 2011 031 572
- US-A1- 2011 031 572
- US-A1- 2011 291 210
- US-A1- 2011 291 210
- US-A1- 2013 154 438

## Description

The invention relates to nuclear and semiconductor technology, in particular to the creation of power sources based on semiconductor converters using the beta-voltaic effect.

A semiconductor device is known that converts beta radiation into electricity (see patent RU No 2 452 060, IPC H01L31/04); this converter consists a semiconductor plate with a textured surface, a diode structure along the textured surface and a layer of radioactive beta-emitting substance. The textured surface is made as a set of end-to-end channels in the form of a circle, square or other arbitrary shape, and the radioactive substance covers the walls of the channels and most of the rest of the semiconductor surface. The channels and the surface of the semiconductor have micro-relief walls, and the distance between the channels will preferably not exceed 100 microns. Nickel-63, tritium or both are used as a beta emitter. The texture is pre-fabricated using technologies such as photolithography or laser pulse. Taking into account the specifics of technologies used to create textured surfaces, it is rather difficult to ensure the obtaining of the surface of microchannels with a given accuracy, and, consequently, to control the amount of radioisotope to be applied. In this case, it is not possible to obtain a power source with a strictly specified power.

A beta-voltaic battery of high power density is known (see US patent No. 8 487 392, IPC H01L 27/14), comprising a housing, a cover with positive and negative electrodes on it, which are separated by an insulating gasket, and elements 1,2, 3, 4 and 5 located in the housing in a certain order.

Element 1 is a split ring that provides for the movement of current in the battery. Element 1 is made of ceramic material, on which a thick gold layer is deposited to obtain a low-resistance path between the upper and lower parts of the element. A hole is made in the ceramics, in which element 2 is housed.

Element 2 is a beta-voltaic device based on semiconductor SiC, which converts the energy of beta radiation into electricity and is a semiconductor converter. Ohmic contacts are deposited on the upper and lower sides of the semiconductor converter.

Element 3 is a radioisotope element, more precisely, a radioisotope foil combined with a conductive element and an insulating section made of AlN. The conductive element is formed by the deposition method and is a thick gold layer to make a low-resistance path between the upper and lower parts of the element.

Element 4 is an insulating element made of AlN, which is provided with a conductive element that is formed by the deposition method and that is a thick gold layer to make a low-resistance path between the upper and lower parts of the element 4.

Element 5 is an element that is connected in series; it consists of radioisotope foil, insulating material and conductive areas. Conductive sections are formed by the deposition method in the side areas, which are a thick gold layer to make a low-resistance path between the upper and lower parts of the element 5. The conductive material that is nearest to the radioisotope foil is made in the form of a conductive ring, which passes through the entire element and which also serves as a low-resistance path between the upper and lower parts of the element.

To create the known beta-voltaic battery with parallel circuits, elements 1, 2, 3, and 4 are used. Insulating element 4, element 1 with element 2 placed in its opening, element 3 with a radioisotope source, and a cover are sequentially installed in the housing. The above set of elements can be configured in one or several packs connected in parallel as far as the required output power is reached.

To create the known beta-voltaic battery with series and parallel circuits, elements 1, 2, 3, 4, and 5 are used. When integrating the pack into the housing, the following elements are installed one by one: insulating element 4, element 1 with element 2 placed in its opening, element 5 with radioisotope source and a conductive ring, again element 1 with element 2 placed in its opening and element 3 with a radioisotope source. Between each combination of elements 1 and 2, element 5 with a radioisotope source and a conducting ring is installed. Element 3 with a radioisotope source is placed above the topmost element 2. A cover with positive and negative electrodes is placed on the entire structure, thus completing the assembly. The above set of elements can be configured in one or several packs connected in parallel as far as the required output power is reached.

The claimed central radioisotope layer comprises one or more of the following radioisotope elements: tritium, Nickel-63, Phosphorus-33, or Promethium. The applicant selected the known beta-voltaic battery as a prototype.

A disadvantage of the known beta-voltaic battery is that its output electrical parameters (voltage and current) are determined by the number of elements and the type of electrical connection (serial or parallel) during assembly, and this cannot be changed when operated.

Besides, in the parallel-connected beta-voltaic battery, one element 3 with a radioisotope source is placed between element 2 with a SiC-based semiconductor converter and insulating element 4, and the second element 3 is installed above the topmost element 2. As a result, as far as radioisotope elements 3 are concerned, only part of the radiation from one side of the plate of these elements is used, namely, from the side that directly faces the semiconductor converter, which is adjacent to the radioisotope, and, as a result, the efficiency of using an expensive radioisotope decreases (almost twice).

In a beta-voltaic battery with a series and parallel connection, both sides of radioisotope elements 5 are used, and again only one side of elements 3.

**The technical result** that can be obtained by using the proposed beta-voltaic battery is that its specific power can be increased due to the fact that the energy emitted by radioisotope elements will be most fully converted into electrical energy by semiconductor converters and radioisotope element (for example, metallic Nickel-63 or Promethium-147) will be used as electrical contacts between semiconductor converters, and battery packs can be electrically connected to the controller. This technical result is achieved by the fact that in a beta-voltaic battery comprising a housing and a cover, semiconductor converters based on p-n or p-i-n structures made of silicon, A3B5 compounds, solid solutions of aluminum, gallium, nitrogen or phosphorus (or all of them), made with profiled doping, insulating and radioisotope elements and conductive contacts, configured in one or several packs, connected in parallel and (or) in series to achieve the required output power, semiconductor converters with profiled doping are made with an increased space charge region over the entire width of the semiconductor converter.

The pack is assembled from semiconductor converters, whose opposite-polar surfaces face each other, with conductive radioisotope elements being placed between the opposite-polar surfaces.

The packs are separated by insulating elements, equipped with evenly spaced grooves along their entire perimeter, the number of which is as high as twice the number of packs in the beta-voltaic battery or higher.

Conductive contacts are provided in the opposite grooves, one of which is brought to the lower surface of the insulating element in the area of the groove, and the second contact is brought to the upper surface, and the conductive contacts of the insulating elements are designed so that they can be electrically connected both to conductive contacts of the outermost semiconductor converters of each pack, which are adjacent to the specified contacts, and to the controller.

In a particular case of embodiment, the highly enriched Nickel-63 isotope is used as a conductive radioisotope element.

In a particular case of embodiment, the conductive contacts of the outermost semiconductor converters of the packs are made by depositing on n- or p- layers of a conductive metal, for example, copper.

In a particular case of embodiment, the conductive contacts of the outermost semiconductor converters of the packs are made by depositing on n- or p- layers of Nickel-63 of suitable thickness.

Due to the fact that the semiconductor converters (hereinafter referred to as the 'converter') are made with profiled doping and have an increased spatial charge region throughout the entire thickness of p-n or p-i-n structure of the converter, the beta radiation energy can be converted into electrical energy in the most complete way, since the recombination of charge carriers is reduced and beta particles are being absorbed in the layer of the converter material to a less extent, therefore, the specific power of the beta-voltaic battery (hereinafter referred to as the 'battery') increases.

On top of that, the space charge region, in which the energy of beta particles is converted into electric current over the entire width of the p-n or p-i-n structure, is wider, which makes it possible to use radiation from the side of the radioisotope element that faces the p-layer of the converter, therefore, multilayer structures "radioisotope element - converter" can be fabricated, which also contributes to increasing the specific power of the battery.

Assembling a pack of converters, opposite-polar surfaces of which face each other and between which conductive radioisotope elements are placed, makes it possible, firstly, to use radiation that is emitted by the radioisotope element on both sides, and convert this radiation into electrical energy; secondly, to electrically interconnect the converters in series by using the conductive radioisotope element as an electrical contact between these converters.

Due to the fact that the packs are separated by insulating elements, along the perimeter of which grooves are evenly spaced, the number of which is equal to twice the number of packs in the beta-voltaic battery (hereinafter referred to as the 'battery') or exceeds the specified number, and due to the fact that there are conductive contacts, during the assembly process of the battery by turning the insulating elements relative to each other on one pitch between the grooves, free grooves may be obtained without contacts above all grooves with conductive contacts and conductors can be placed in these grooves and, thereby, the conductive contacts can be electrically connected with the controller.

Due to the fact that one of the conductive contacts is brought to the lower surface of the insulating element in the region of the slot, and the second contact is brought to the upper surface and they can be electrically connected to the conductive contacts that are adjacent to the insulating element of the extreme converters of each pack, a negative charge with n the layer of the converter adjacent to the insulating element of the converter from the bottom can be brought to one contact, and the positive charge from the p-layer of the converter, lying present to the insulating member from above, can be output to the second contact, and, thus, can be created to electrically connect the battery packs converters with conductive contacts arranged in the opposite grooves of the insulating elements

Due to the insulating elements of conductive contacts in the opposite grooves and the availability of free slots above the contacts, each battery pack can be electrically connected to the controller.

Due to the fact that Nickel-63 enriched to 80% or higher is used as a conductive radioisotope element, which is applied to the n-layers of the converters, the following is possible: 1) the specific electric power of the battery can be increased, and 2) Nickel- 63 can be used as an electrical contact between the n-layer of one converter, and the p-layer of the adjacent converter.

Due to the fact that the conductive contacts of the extreme converters of the packs are applied to n- or p- layers of conductive metal such as copper, these can be electrically connected to the conductive contacts of insulating elements.

Since the conductive contacts in the extreme converters of the packs are applied on Nickel-63 n- or p- layers and have an optimal thickness, these can be electrically connected to the conductive contacts of the insulating elements using a conductive radioisotope element, which serves as a contact between them, and also the battery power density can be increased.

The claimed inventions are illustrated by drawings, representing the following:
FIG. 1 - battery assembled with controller;
FIG. 2 - extension element of FIG. 1;
FIG.3 - section B-B in FIG. 1;
FIG. 4 - section A-A in FIG. 1;

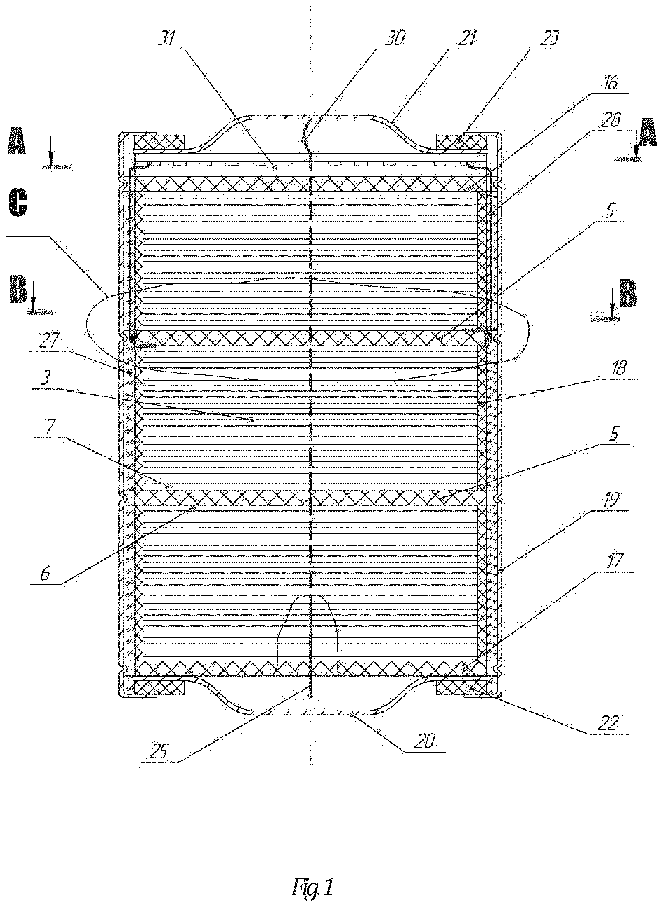

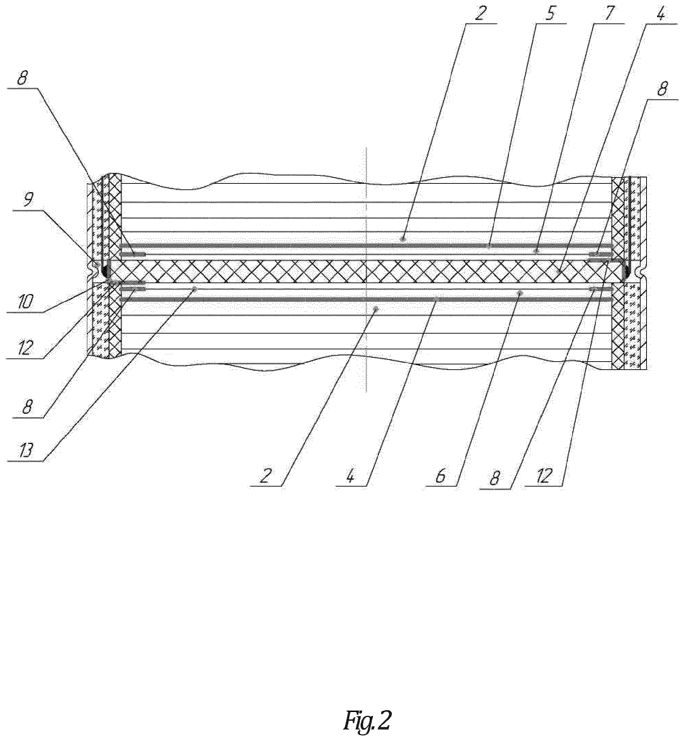

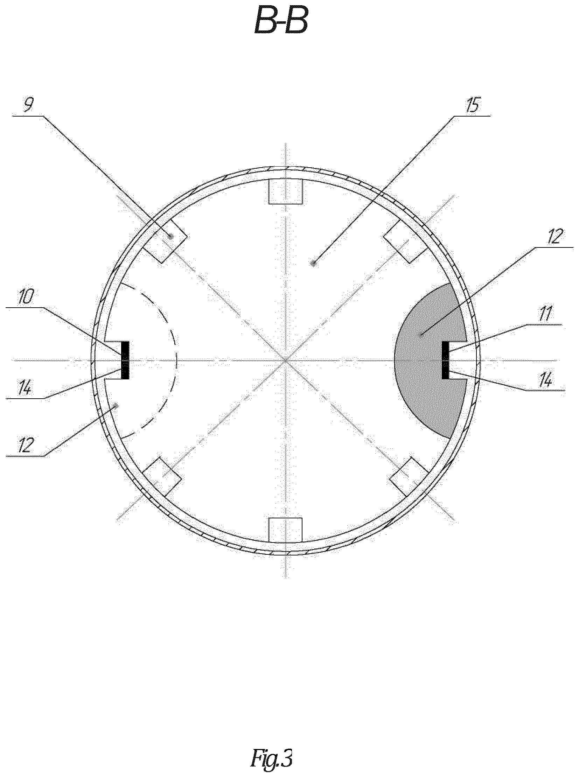

The proposed battery 1 comprises (see FIG. 1 and 2) converters 2 stacked to make one or several packs 3, and insulating elements 4 between them. FIG. 1 shows the battery comprising three packs. Converters 2 in packs 3, whose opposite-polar surfaces face each other, with conductive radioisotope elements 5 being placed between the opposite-polar surfaces. A highly enriched Nickel-63 radioisotope deposited on n-layers of converters 2 is used as a radioisotope element 5. The upper 6 and lower 7 converters of each pack 3 are provided with contacts 8, which are created by applying, respectively, on n- or players of conductive material, such as copper, while contacts 8 on the upper converters 6 are applied to n- layers, and on the lower converters 7 these are applied on p- layers. The insulating elements 4 are provided with grooves 9, which are evenly spaced around the entire perimeter of the insulating element 4, and the total number of grooves 9 is equal to twice the number of packs 3 in battery 1 or exceeds this number depending on the embodiment of battery 1. In the opposite grooves 9 of the insulating elements 5 (see FIG. 3) contacts 10 and 11 are provided, and the remaining grooves 9 are unoccupied. Each contact 10 comprises a conductive section 12, which is deposited on the bottom surface 13 of the insulating element 5, where the groove 9 is located, and the conductive section 14, which is located directly in the groove 9 and is connected to it. Each contact 11 comprises a conductive section 12, which is deposited on the upper surface 15 of the insulating element 5, where the opposite groove 9 is located, and the conductive section 14, which is located directly in the groove 9 and is connected to it.

If the conductive contacts of the extreme converters 6 and 7 of the packs 3 are applied on their n- or p- layers of the radioisotope element 5, in particular on Nickel-63, and have the optimum thickness, their electrical connection with contacts 11 and 10 in grooves 9 of the insulating elements 4, 16 and 17 is implemented through the direct electrical contact of the radioisotope element 4 with the conductive sections 12.

On the upper insulating element 16, only contact 10 is provided, which is connected to the upper converter 6 of the pack 3 located under it, and on the lower insulating element 17, only contact 11 is provided, which is connected to the lower semiconductor converter 7 of the pack 3 above it. When assembling the battery 1, each insulating element 5 and the upper insulating element 16, which are located above the lower insulating element 17, rotate relative to each other by a pitch between the grooves 9, and, as a result, the unoccupied grooves 9 without contacts 10 and 11 in them are placed above all the grooves, in which contacts 10 and 11 are provided. Each pack 3 is installed in the insulating bush 18 with its outer surface.

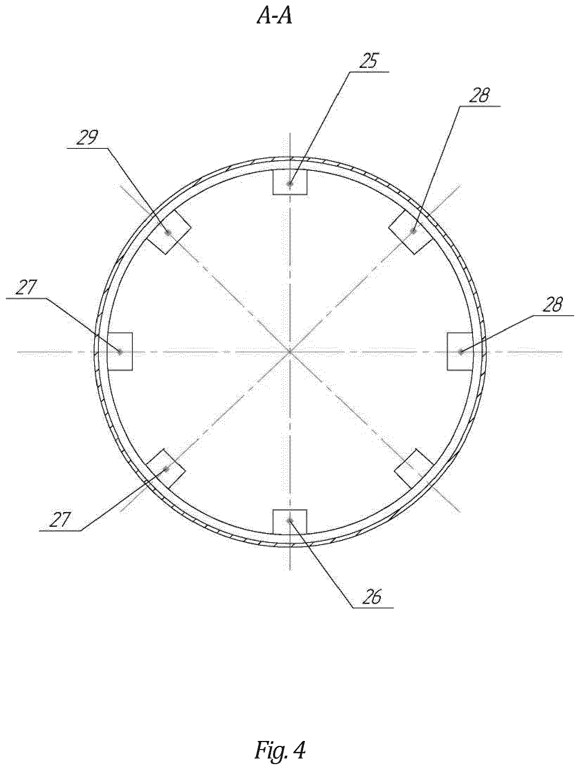

Battery 1 is placed in housing 19, in which the lower negative electrode 20 and the upper positive electrode 21 are secured, for installation of which in housing 19, insulating gaskets 22 and 23 are used. The space between housing 19 and packs 3 is filled with dielectric mastic or compound 24. The lower electrode 20, contact 11 of the lower insulating element 17, contacts 10 and 11 of the insulating elements 5, contact 10 of the upper insulating element 16 and the upper electrode 21 are connected (see FIG. 4) with conductors 25, 26, 27, 28, 29 and 30, with controller 31, which is installed in housing 19 above the upper insulating element 16.

The proposed battery 1 and its housing 19, insulating elements 5, 16 and 17 and semiconductor converters 2, 6 and 7 can have a square or rectangular cross section, and electrodes 20 and 21 can be placed in the upper part of battery 1.

Electric energy is produced in battery 1 as follows.

Leaving the surface of the radioisotope element 5, beta particles fall on converters 2 that are adjacent to the specified element. Due to its high energy, beta particles fly through p- or n- doped layers of adjacent converters 2. Getting into the space charge region (SCR), beta particles collide with atoms of this region. As the electric bond between the atom and electrons is much weaker in the SCR than in the p- and n-layers of converters 2, the electron is detached from the atom and an electron-hole pair is formed. The free electron begins to rush into the region of increased negative charge i.e. into the n-layer of converter 2. Accordingly, the remaining electrons in the SCR tend to fill the resulting absence of an electron and also tend to the negative charge region, thereby, virtually, an atom, in which there is no electron, moves to the positively charged region i.e. to the p-layer of converter 2. Thus, the electric potential difference arises between the p-layer and the n-layer of converter 2 i.e. voltage. The beta particle continues its movement in the SCR region and generates electron-hole pairs until all of its energy has been exhausted.

Since converters 2 are assembled to make packs 3, and the opposite-polar surfaces in them face each other, and the conductive radioisotope elements 5 are placed between the opposite-polar surfaces, the converters 2 in packs 3 are, as a result, electrically connected in series. From upper (6) and lower (7) converters of each pack 3, contacts 8 of which are connected, through conductive sections 12, with contacts 11 and 10 of insulating elements 4, 16 and 17 placed in grooves 9, negative charge from the n-layer of the lower converter 7 enters contact 10, and positive charge from the p- layer of upper converter 6 enters contact 11. From contacts 10 and 11, negative and positive charges are supplied to controller 31 through conductors 26, 27, 28 and 29, and voltage is supplied from the controller via conductors 25 and 30 to lower (20) and upper (21) electrodes.

## Claims

1. Beta-voltaic battery (1) comprising a housing (19) and a cover, semiconductor converters (2, 6, 7) based on p-n or p-i-n structures made of silicon, A3B5 compounds, solid solutions of aluminum, gallium, nitrogen or phosphorus (or all of them), made with profiled doping, insulating and radioisotope elements (4, 5, 16, 17) and conductive contacts (8, 10, 11) that can be configured to make one or several packs (3) connected in parallel and (or) in series to achieve the required output power, wherein the semiconductor converters (2, 6, 7) are made with an area of space charge over the entire width of the semiconductor converter (2, 6, 7) stacked to form at least one pack (3) assembled from the semiconductor converters (2, 6, 7), with opposite-polar surfaces of which facing each other, current-carrying radioisotope elements (5) are placed between opposite-polar surfaces, the packs (3) are separated by insulating elements (4, 16, 17), **characterized in that** grooves (9) are evenly spaced along the perimeter of the insulating elements (4, 16, 17), wherin the number of the grooves (9) is equal to or more than twice the number of packs (3) in the battery (1); the opposite grooves (9) are provided with conductive contacts (8), one of which is brought to the lower surface of the insulating element (4) in the region of the groove (9), and the second one is brought to the upper surface (15), while the conductive contacts (8, 10, 11) of the insulating elements (4, 16, 17) being designed in such a way that these can be electrically connected to both the conductive contacts (8, 10, 11) of the extreme semiconductor converters (2, 6, 7) of each pack (3) and a controller (31).

2. Battery (1) according to claim 1, **characterized in that** a highly enriched Nickel-63 is used as a radioisotope element (5), which is deposited on n- layers of semiconductor converters (2, 6, 7).

3. Battery (1) according to claim 1 **characterized in that** the conductive contacts of the outermost semiconductor converters (2, 6, 7) of the packs (3) are made by depositing on n- or p- layers of a conductive metal, for example, copper.

4. Battery (1) according to claim 1**characterized in that** the conductive contacts (8, 10, 11) of the outermost semiconductor converters (2, 6, 7) of the packs (3) are made by depositing on n- or p- layers of Nickel-63 and have suitable thickness.

## Patentansprüche

1. Beta-Voltaik-Batterie (1), umfassend ein Gehäuse (19) und eine Abdeckung, Halbleiterwandler (2, 6, 7) auf der Basis von p-n- oder p-i-n-Strukturen aus Silizium, A3B5-Verbindungen, Mischkristalle aus Aluminium, Gallium, Stickstoff oder Phosphor (oder allen davon), mit profilierten Dotier-, Isolier- und Radioisotop-Elementen (4, 5, 16, 17) und leitenden Kontakten (8, 10, 11), die so konfiguriert sein können, dass sie ein oder mehrere Packs (3) bilden, die parallel und (oder) in Reihe geschaltet sind, um die erforderliche Ausgangsleistung zu erreichen,
wobei die Halbleiterwandler (2, 6, 7) mit einer Raumladungsfläche über die gesamte Breite des Halbleiterwandlers (2, 6, 7) hergestellt sind, die so gestapelt sind, dass sie mindestens ein Pack (3) bilden, das aus den Halbleiterwandlern (2, 6, 7) zusammengesetzt ist, wobei ihre entgegengesetzt-polaren Oberflächen einander zugewandt sind, stromführende Radioisotop Elemente (5) zwischen entgegengesetztpolare Oberflächen angeordnet sind, die Packs (3) durch isolierende Elemente (4, 5, 16, 17) getrennt sind,
**dadurch gekennzeichnet, dass** Nuten (9) entlang des Umfangs der isolierenden Elemente (4, 5, 16, 17) gleichmäßig beabstandet sind, wobei die Anzahl der Nuten (9) gleich oder mehr als doppelt so hoch wie die Anzahl der Packs (3) in der Batterie (1) ist; die gegenüberliegenden Nuten (9) mit leitenden Kontakten (8) versehen sind, von denen einer an die untere Oberfläche des isolierenden Elements (4) im Bereich der Nut (9) gebracht wird und der zweite an die obere Oberfläche (15) gebracht wird, während die leitenden Kontakte (8, 10, 11) der isolierenden Elemente (4, 5, 16, 17) so ausgebildet sind, dass diese sowohl mit den leitenden Kontakten (8, 10, 11) der extremen Halbleiterwandler (2, 6, 7) eines jeden Packs (3) als auch mit einer Steuerung (31) elektrisch verbunden werden können.

2. Batterie (1) nach Anspruch 1, **dadurch gekennzeichnet, dass** als Radioisotop Element (5) hochangereichertes Nickel-63 verwendet wird, das auf n-Schichten von Halbleiterwandlern (2, 6, 7) abgeschieden wird.

3. Batterie (1) nach Anspruch 1, **dadurch gekennzeichnet, dass** die leitenden Kontakte der äußersten Halbleiterwandler (2, 6, 7) der Packs (3) durch Abscheidung auf n- oder p-Schichten eines leitenden Metalls, zum Beispiel Kupfer, hergestellt sind.

4. Batterie (1) nach Anspruch 1, **dadurch gekennzeichnet, dass** die leitenden Kontakte (8, 10, 11) der äußersten Halbleiterwandler (2, 6, 7) der Packs (3) durch Abscheiden auf n- oder p-Schichten aus Nickel-63 hergestellt sind und eine geeignete Dicke aufweisen.

## Revendications

1. Batterie bêtavoltaïque (1) comprenant un boîtier (19) et une couverture, des convertisseurs semi-conducteurs (2, 6, 7) sur la base de structures p-n ou p-i-n faites de silicium, de composés A3B5, de solutions solides d'aluminium, de gallium, d'azote ou de phosphore (ou l'ensemble de ceux-ci), faits avec des éléments profilés dopants, isolants et radioisotopes (4, 5, 16, 17) et des contacts conducteurs (8, 10, 11) qui peuvent être configurés pour former un ou plusieurs packs (3) connectés en parallèle et (ou) en série pour atteindre la puissance de sortie requise,
dans laquelle les convertisseurs semi-conducteurs (2, 6, 7) sont faits avec une zone de charge d'espace sur toute la largeur du convertisseur semiconducteur (2, 6, 7) empilée pour former au moins un pack (3) assemblé à partir des convertisseurs semi-conducteurs (2, 6, 7), des surfaces polaires de ceux-ci étant opposées en vis-à-vis l'une de l'autre, des éléments radioisotopes porteurs de courant (5) sont placés entre les surfaces polaires opposées, les packs (3) étant séparés par des éléments isolants (4, 5, 16, 17),
**caractérisée en ce que** des rainures (9) sont espacées uniformément le long du périmètre des éléments isolants (4, 5, 16, 17), dans laquelle le nombre de rainures (9) est égal ou supérieur à deux fois le nombre de packs (3) dans la batterie (1) ; les rainures (9) opposées sont dotées de contacts conducteurs (8), dont l'un est amené vers la surface inférieure de l'élément isolant (4) dans la région de la rainure (9) et le second est amené vers la surface supérieure (15), tandis que les contacts conducteurs (8, 10, 11) des éléments isolants (4, 5, 16, 17) sont conçus de telle sorte que ceux-ci peuvent être électriquement connectés à la fois aux contacts conducteurs (8, 10, 11) des convertisseurs semi-conducteurs (2, 6, 7) extrêmes de chaque pack (3) et à un contrôleur (31).

2. Batterie (1) selon la revendication 1, **caractérisée en ce qu'**un nickel 63 hautement enrichi est utilisé à titre d'élément radioisotope (5), qui est déposé sur des couches n de convertisseurs semi-conducteurs (2, 6, 7).

3. Batterie (1) selon la revendication 1, **caractérisée en ce que** les contacts conducteurs des convertisseurs semi-conducteurs (2, 6, 7) les plus à l'extérieur des packs (3) sont faits par déposition de couches n ou p d'un métal conducteur, par exemple, de cuivre.

4. Batterie (1) selon la revendication 1, **caractérisée en ce que** les contacts conducteurs (8, 10, 11) des convertisseurs semi-conducteurs (2, 6, 7) les plus à l'extérieur des packs (3) sont faits par déposition de couches n ou p de nickel 63 et ont une épaisseur appropriée.
